# EUROPÄISCHE PATENTSCHRIFT

(11) **EP 3 585 719 B1**
(45) Veröffentlichungstag und Bekanntmachung des Hinweises auf die Patenterteilung: **07.04.2021**
(21) Anmeldenummer: 18705003.4
(22) Anmeldetag: 20.02.2018
(51) Int. Cl.: B66B 23/00, B66B 25/00

(54) **VERFAHREN UND EINE VORRICHTUNG ZUM ERZEUGEN EINES 3D-MODELLS EINER TRAGENDEN STRUKTUR EINER FAHRTREPPE ODER EINES FAHRSTEIGES**
METHOD AND DEVICE FOR CREATING A 3D-MODEL OF AN ESCALATOR OR A MOVING WALKWAY
UNE MÉTHODE ET UN DISPOSITIF DE CRÉATION D'UN MODÈLE 3D D'UNE STRUCTURE SUPPORTANT UN ESCALATEUR OU UN TAPIS ROULANT

(30) Priorität: 27.02.2017 EP 17158053
(43) Veröffentlichungstag der Anmeldung: 01.01.2020
(73) Patentinhaber: Inventio AG, 6052 Hergiswil (CH)
(72) Erfinder: EDER, Christoph, 1220 Wien (AT); SCHÜTZ, Richard, 1100 Wien (AT); NOVACEK, Thomas, 2320 Schwechat (AT); WAGENLEITNER, Georg, 4575 Rossleithen (AT)
(86) Internationale Anmeldenummer: PCT/EP2018/054121
(87) Internationale Veröffentlichungsnummer: WO 2018/153846

(56) Entgegenhaltungen:
- EP-A1- 2 933 779
- JP-A- 2015 030 604
- JP-A- 2015 202 915
- US-A1- 2005 088 520

## Beschreibung

Die vorliegende Erfindung betrifft ein Verfahren und eine Vorrichtung zum Erzeugen eines 3D-Modells von Strukturkomponenten einer tragenden Struktur einer Fahrtreppe oder eines Fahrsteiges und zum Vermessen der Strukturkomponenten, wie es insbesondere im Rahmen einer Modernisierung einer Fahrtreppe oder eines Fahrsteiges eingesetzt werden kann.

Fahreinrichtungen in Form von Fahrtreppen oder Fahrsteigen werden meist innerhalb von Bauwerken dazu eingesetzt, um Personen zwischen zwei festgelegten Orten befördern zu können. Bei Fahrtreppen, welche teilweise auch als Rolltreppen bezeichnet werden, befinden sich die beiden Orte dabei auf unterschiedlichen Niveaus und Personen werden entlang eines stark geneigten Förderwegs befördert, wohingegen bei Fahrsteigen die beiden Orte auf einem gleichen Niveau oder lediglich geringfügig unterschiedlichen Niveaus liegen und die Personen ebenerdig beziehungsweise entlang eines lediglich geringfügig geneigten Förderwegs befördert werden. Nachfolgend werden Fahrtreppen und Fahrsteige unter dem allgemeineren Begriff Fahreinrichtungen zusammengefasst.

Die Fahreinrichtung verfügt im Allgemeinen über eine Fördereinrichtung mit mehreren entlang eines umlaufenden Verfahrwegs verlagerbaren Tritteinheiten. Die Tritteinheiten sind dabei zumindest innerhalb eines sogenannten Förderbereichs von außen her zugänglich, sodass Passagiere beispielsweise von einem Eintrittsbereich her kommend auf eine der Tritteinheiten in dem Förderbereich steigen können, dann entlang des Förderwegs befördert werden und letztendlich an einem gegenüberliegenden Austrittsbereich wieder aussteigen können. Der Förderbereich wird teilweise auch als Vorlauf-Bereich der Fördereinrichtung bezeichnet, wobei die umlaufende Fördereinrichtung in einem Rücklauf-Bereich unterhalb des Vorlauf-Bereichs zurückläuft und dabei natürlich nicht von Passagieren betreten werden kann. Bei Fahrtreppen werden die Tritteinheiten meist als Trittstufen bezeichnet, bei Fahrsteigen werden die Tritteinheiten in der Regel als Paletten bezeichnet. Die Tritteinheiten sind im Allgemeinen entlang des Verfahrwegs hintereinander angeordnet und jeweils mindestens an einer Kette beziehungsweise einem Band befestigt, um auf diese Weise ein Stufenband beziehungsweise Palettenband zu bilden. Die durch das Stufenband beziehungsweise das Palettenband gebildete Fördereinrichtung kann somit als derjenige Teil der Fahreinrichtung verstanden werden, der relativ zu einem stationären Teil der Fahreinrichtung verlagerbar ist. Standardmäßig weist die Fahreinrichtung auch umlaufende Handläufe auf, die das Stufenband beziehungsweise Palettenband längsseitig säumen. An diesen können sich die Benutzer festhalten, weshalb die umlaufenden Handläufe ebenfalls Teile der Fördereinrichtung sein können.

Zusätzlich zu der Fördereinrichtung verfügt die Fahreinrichtung über eine tragende Struktur, mithilfe derer die Fahreinrichtung innerhalb des Bauwerks befestigt werden kann und über die das Gewicht der Fahreinrichtung an das Bauwerk abgeleitet wird. Die tragende Struktur ist dabei meist als Fachwerk ausgebildet. Ein solches Fachwerk ist aus einer Vielzahl von Strukturkomponenten zusammengesetzt. Solche Strukturkomponenten können unter anderem Querstreben, Längsstreben, Diagonalstreben, Adapterbauteile und dergleichen mehr sein. Das Fachwerk ist dabei derart ausgelegt und angeordnet, dass es einerseits an tragende Strukturen des Bauwerks montiert werden kann und andererseits Komponenten der Fördereinrichtung in und an das Fachwerk montiert werden können. Eine geometrische und strukturelle Ausbildung der durch das Fachwerk gebildeten tragenden Struktur der Fahreinrichtung sollte somit sowohl geometrischen und strukturellen Randbedingungen innerhalb des aufnehmenden Bauwerks als auch entsprechenden Gegebenheiten anderer Komponenten der Fahreinrichtung, wie insbesondere der Fördereinrichtung, Rechnung tragen.

Nach einer gewissen Betriebsdauer kann es erforderlich sein, eine Fahrtreppe beziehungsweise einen Fahrsteig zu modernisieren. Hierbei können beispielsweise verschlissene Komponenten der Fahreinrichtung ersetzt werden. Alternativ oder ergänzend können Komponenten der Fahreinrichtung durch entsprechende modernere Komponenten ersetzt werden, um beispielsweise eine Leistungsfähigkeit, einen Komfort und/oder eine Langlebigkeit der ursprünglichen Fahreinrichtung zu verbessern.

Alternativ zu einer Modernisierung einer bestehenden Fahreinrichtung könnte die Fahreinrichtung auch als Ganzes ersetzt werden. Dabei kann es zwar kostengünstiger sein, eine Ersatz-Fahreinrichtung standardisiert in einem Werk zu fertigen anstatt eine bestehende Fahreinrichtung zu modernisieren. Allerdings können zusätzlicher Aufwand und Kosten entstehen, um die Ersatzfahreinrichtung zu ihrem Einsatzort zu transportieren. Insbesondere kann es erheblichen Aufwand mit sich bringen, eine Ersatz-Fahreinrichtung als sehr großes Bauteil in ein existierendes Gebäude einzubringen, da dabei oft Wände des Gebäudes und/oder andere Hindernisse zumindest teilweise entfernt werden müssen.

Im Rahmen einer Modernisierung einer Fahreinrichtung wird typischerweise eine bestehende tragende Struktur der Fahreinrichtung, insbesondere ein bestehendes Fachwerk, zunächst ausgeräumt, d.h., insbesondere Komponenten der Fahreinrichtung, welche modernisiert werden sollen, werden entfernt. Insbesondere werden einige oder alle Komponenten der Fördereinrichtung, d.h. beispielsweise das Stufenbeziehungsweise Palettenband und/oder Antriebs- und Umlenkeinheiten, entfernt. Anschließend wird die verbleibende tragende Struktur der Fahreinrichtung zur Aufnahme neuer Komponenten vorbereitet, d.h., insbesondere gereinigt und eventuell mit geeigneten Adapterplatten oder Adaptermodulen versehen, um dann anschließend neue Komponenten an der tragenden Struktur montieren zu können.

WO 2004/035452 A1 beschreibt ein Verfahren zur Modernisierung einer bestehenden Fahrtreppe. EP 16175491.6 beschreibt ebenfalls ein Verfahren zur Modernisierung einer bestehenden Fahrtreppe oder eines bestehenden Fahrsteiges JP 2015 202915 A beschreibt ein Verfahren zur Inspektion der Fahrtreppe mit einer Kamera. EP 2933779 A1 beschreibt ein Verfahren zum Erzeugen des 3D-Modells basierend den aufgenommen 3D-Kamera.

Herkömmlich wird beim Modernisieren einer bestehenden Fahreinrichtung nach dem Entfernen zu ersetzender Komponenten zunächst das verbleibende Fachwerk präzise vermessen, damit dieses später beispielsweise mithilfe von Adapterplatten und Adaptermodulen an aufzunehmende Ersatzkomponenten angepasst werden kann. Ein solches Vermessen wird dabei herkömmlich von spezialisiertem Personal durchgeführt, welches beispielsweise sowohl die Ersatzkomponenten und deren Einbauanforderungen genau kennt, als auch weiß, welche Maße der verbleibenden tragenden Fachwerkstruktur vermessen werden müssen, um ein späteres Einpassen der Ersatzkomponenten sowie ein eventuelles Konstruieren oder Anpassen von Adapterplatten und Adaptermodulen mit ausreichender Genauigkeit vorbereiten zu können. Ein solches Vermessen war aufgrund der benötigten Expertise des Fachpersonals sowie der Notwendigkeit, dass das Fachpersonal die Fahreinrichtung vor Ort inspiziert und vermisst, sowohl teuer als auch zeitintensiv.

Es kann unter anderem ein Bedarf an einem Verfahren beziehungsweise einer Vorrichtung bestehen, mithilfe derer insbesondere im Rahmen von Modernisierungsmaßnahmen eine tragende Struktur einer Fahrtreppe oder eines Fahrsteigs hinsichtlich ihrer Strukturkomponenten mit geringem personellen und/oder finanziellem Aufwand vermessen werden kann. Besonders kann ein Bedarf an einem Verfahren beziehungsweise einer Vorrichtung bestehen, mittels derer die Strukturkomponenten der tragenden Struktur der Fahreinrichtung vermessen werden können, ohne dass hierzu qualifiziertes Fachpersonal vor Ort die Fahreinrichtung vermessen muss.

Einem solchen Bedarf kann durch das Verfahren beziehungsweise die Vorrichtung gemäß einem der unabhängigen Ansprüche entsprochen werden. Vorteilhafte Ausführungsformen sind in den abhängigen Ansprüchen sowie der nachfolgenden Beschreibung definiert.

Gemäß einem ersten Aspekt der Erfindung wird ein Verfahren zum Erzeugen eines 3D-Modells von Strukturkomponenten einer tragenden Struktur einer Fahrtreppe oder eines Fahrsteiges vorgeschlagen. Die Fahrtreppe beziehungsweise der Fahrsteig weist dabei eine Fördereinrichtung mit mehreren entlang eines umlaufenden Verfahrwegs verlagerbaren Tritteinheiten auf, wobei die Tritteinheiten entlang des Verfahrwegs hintereinander angeordnet sind. Das Verfahren weist die folgenden Schritte auf: (a) Fixieren einer Bildaufnahmeeinrichtung an der Fördereinrichtung; (b) Entfernen zumindest einer der Tritteinheiten, um einen visuellen Zugang zu darunterliegenden zu vermessenden Strukturkomponenten zu eröffnen; (c) vor dem Aufnehmen von Bildaufnahmen durch die Bildaufnahmeeinrichtung, ortsfeste Anbringung mindestens einer Referenzmarke an der Fahrtreppe beziehungsweise am Fahrsteig an mindestens einer Stelle innerhalb des Verfahrwegs, wobei die Referenzmarke für die Bildaufnahmeeinrichtung eindeutig erkennbar ist; (d) umlaufendes Verlagern der Fördereinrichtung zusammen mit der daran fixierten Bildaufnahmeeinrichtung zumindest über Teilbereiche des Verfahrwegs; (e) Aufnehmen von Bildaufnahmen der zu vermessenden Strukturkomponenten mittels der Bildaufnahmeeinrichtung von mehreren Positionen entlang des Verfahrwegs aus; und (f) Erzeugen des 3D-Modells zumindest von Teilbereichen der Strukturkomponenten der tragenden Struktur basierend auf den aufgenommenen Bildaufnahmen und unter Zuhilfenahme der mindestens einen, mitaufgenommenen Referenzmarke. Die Schritte können in der angegebenen oder in einer anderen Reihenfolge ausgeführt werden. Insbesondere kann Schritt (b) vor Schritt (a) erfolgen. Die Schritte (d), (e), (f) können nacheinander oder gleichzeitig ausgeführt werden.

Bezüglich der vorliegenden Schrift ist das Merkmal "3D-Modell" als virtuelles 3D-Modell zu verstehen. Genauer gesagt ist dieses 3D-Modell eine möglichst maßstabsgerechte dreidimensionale Wiedergabe der aufgenommenen Struktur in digitalisierter Form, wobei die einzelnen Punkte des 3D-Modells im virtuellen Raum durch Koordinaten in drei Dimensionen und/oder durch Vektorkoordinaten definiert sind. Solche virtuellen 3D-Modelle können beispielsweise in ein 3D-CAD-System übernommen werden. Das 3D-CAD-System bietet die Möglichkeit, Distanzen und Lagen von Flächen und Kanten des 3D-Modells auszumessen. Vorzugsweise sind die einzufügenden neuen Komponenten ebenfalls im 3D-CAD-System konstruiert worden. Diese können nun virtuell in das 3D-Modell eingefügt und optimal positioniert werden, so dass sich Adapterbauteile direkt in der virtuellen Umgebung des 3D-Modells konstruieren lassen. Diese Adapterbauteile ermöglichen eine stabile, zuverlässige und positionspräzise Verbindung des alten, bestehenden Fachwerkes mit den neu einzufügenden Komponenten.

Gemäß einem zweiten Aspekt der Erfindung wird ein Verfahren zum Vermessen von Strukturkomponenten einer tragenden Struktur einer Fahrtreppe oder eines Fahrsteiges vorgeschlagen. Das Verfahren umfasst ein Erzeugen eines 3D-Modells der Strukturkomponenten der tragenden Struktur mittels eines Verfahrens gemäß einer Ausführungsform des ersten Aspekts der Erfindung und ein Vermessen der Strukturkomponenten anhand des 3D-Modells.

Gemäß einem dritten Aspekt der Erfindung wird ein Verfahren zum Modernisieren einer Fahrtreppe oder eines Fahrsteigs vorgeschlagen. Das Verfahren weist die folgenden Schritte auf: (i) Ermitteln von Abmessungen innerhalb einer tragenden Struktur der Fahrtreppe beziehungsweise des Fahrsteiges durch Vermessen von Strukturkomponenten der tragenden Struktur mittels des Verfahrens gemäß einer Ausführungsform des zweiten Aspekts der Erfindung; (ii) Entfernen von an der tragenden Struktur befestigten alten Komponenten der Fahrtreppe beziehungsweise des Fahrsteigs; und (iii) Anbringen von neuen Komponenten der Fahrtreppe beziehungsweise des Fahrsteigs an der tragenden Struktur, wobei eine Positionierung der neuen Strukturkomponenten an der tragenden Struktur unter Berücksichtigung der zuvor ermittelten Abmessungen innerhalb der tragenden Struktur erfolgt.

Gemäß einem vierten Aspekt der Erfindung wird eine Vorrichtung zum Erzeugen eines 3D-Modells von Strukturkomponenten einer tragenden Struktur einer Fahrtreppe oder eines Fahrsteiges vorgeschlagen. Die Fahrtreppe beziehungsweise der Fahrsteig sind dabei gleich oder entsprechend wie oben bezüglich des ersten Aspekts der Erfindung erläutert ausgebildet. Die Vorrichtung weist eine Bildaufnahmeeinrichtung, eine Fixiereinrichtung und eine Recheneinrichtung auf. Die Bildaufnahmeeinrichtung ist dazu eingerichtet, Bildaufnahmen der zu vermessenden Strukturkomponenten aufzunehmen. Die Fixiereinrichtung ist dazu eingerichtet, die Bildaufnahmeeinrichtung an der Fördereinrichtung zu fixieren. Die Recheneinrichtung ist dazu eingerichtet, das 3D-Modell zumindest von Teilbereichen der Strukturkomponenten der tragenden Struktur basierend auf von der Bildaufnahmeeinrichtung aufgenommenen Bildaufnahmen zu erzeugen. Die Vorrichtung kann somit speziell dazu konfiguriert sein, ein Verfahren gemäß einer Ausführungsform des ersten beziehungsweise des zweiten Aspekts der Erfindung auszuführen beziehungsweise bei einem solchen Verfahren eingesetzt zu werden.

Mögliche Merkmale und Vorteile von Ausführungsformen der Erfindung können unter anderem und ohne die Erfindung einzuschränken als auf nachfolgend beschriebenen Ideen und Erkenntnissen beruhend angesehen werden.

Wie einleitend angemerkt, mussten im Rahmen herkömmlicher Modernisierungsmaßnahmen verbleibende Strukturkomponenten einer tragenden Struktur einer Fahreinrichtung bisher aufwendig von spezialisierten Fachpersonal vermessen werden, um nachfolgend Ersatzkomponenten der Fördereinrichtung geeignet vorbereiten und in die verbleibende tragende Struktur einpassen zu können.

Mit dem hier vorgeschlagenen Verfahren beziehungsweise unter Verwendung der hier vorgeschlagenen Vorrichtung kann die Vermessung der tragenden Struktur einer Fahreinrichtung erheblich vereinfacht und/oder teilweise automatisiert werden.

Kurz zusammengefasst wird vorgeschlagen, ein 3D-Modell, das heißt eine möglichst maßstabsgerechte dreidimensionale Wiedergabe insbesondere in digitalisierter Form von Strukturkomponenten der tragenden Struktur der Fahreinrichtung mithilfe von Bildaufnahmen zu erzeugen, um dieses 3D-Modell dann vermessen zu können. Die Bildaufnahmen werden dabei durch eine an der Fördereinrichtung der Fahreinrichtung fixierte Bildaufnahmeeinrichtung aufgenommen. Insbesondere werden mehrere Bildaufnahmen aufgenommen, wobei sich die Positionen, von denen aus die Bildaufnahmen aufgenommen werden, unterscheiden sollen. Hierzu wird die an der Fördereinrichtung fixierte Bildaufnahmeeinrichtung zumindest über Teilbereiche des Verfahrwegs der Fördereinrichtung verlagert. Zu diesem Zweck wird die Fördereinrichtung umlaufend verlagert und von der Bildaufnahmeeinrichtung wird an verschiedenen Positionen entlang des Verfahrwegs jeweils eine Bildaufnahme aufgenommen. Aus der Vielzahl von aus verschiedenen Blickwinkeln aufgenommenen Bildaufnahmen kann dann das gewünschte 3D-Modell erzeugt werden.

Im Rahmen des vorgeschlagenen Verfahrens kann die Bildaufnahmeeinrichtung in unterschiedlicher Weise an der Fördereinrichtung der Fahreinrichtung fixiert werden. Beispielsweise kann die Bildaufnahmeeinrichtung an einer der Tritteinheiten, d.h. an einer Trittstufe beziehungsweise einer Palette, befestigt werden. Hierzu kann eine speziell ausgebildete Koppeleinrichtung eingesetzt werden, die einerseits geeignet mit der Bildaufnahmeeinrichtung zusammenwirkt, d.h. beispielsweise an einem Fuß der Bildaufnahmeeinrichtung zu fixieren ist, und die andererseits mit der Tritteinheit zusammenwirkt, d.h. beispielsweise in Nuten der Tritteinheit zu fixieren ist. Alternativ oder ergänzend kann die Bildaufnahmeeinrichtung an anderen Komponenten der Fördereinrichtung fixiert werden. Beispielsweise kann eine Fixierung an dem Stufenband beziehungsweise Palettenband vorgesehen sein. Insbesondere kann eine Fixierung an einer Förderkette und/oder an Verbindungsachsen innerhalb des Stufenbandes beziehungsweise Palettenbandes vorgesehen sein und gegebenenfalls eine hierfür speziell angepasste Koppeleinrichtung eingesetzt werden. Es ist aber auch möglich, die Bildaufnahmeeinrichtung an einen der umlaufend angeordneten Handläufe oder an beiden Handläufen zu befestigen.

Durch das Fixieren der Bildaufnahmeeinrichtung an der Fördereinrichtung kann die Bildaufnahmeeinrichtung stationär relativ zu der Fördereinrichtung fixiert sein, d.h., eine Blickrichtung der Bildaufnahmeeinrichtung ändert sich nur, wenn die Fördereinrichtung verlagert wird, und eine Blickorientierung der Bildaufnahmeeinrichtung ändert sich nur, wenn sich eine Verlagerungsrichtung der Fördereinrichtung bezüglich ihrer Orientierung ändern sollte. Eine solche starre Fixierung der Bildaufnahmeeinrichtung an der Fördereinrichtung kann einfach implementiert werden. Insbesondere braucht die Bildaufnahmeeinrichtung selbst nicht in der Lage sein, ihre Blickrichtung und/oder Blickorientierung aktiv ändern zu können, sondern es kann genügen, eine statische Bildaufnahmeeinrichtung lediglich mithilfe der Fördereinrichtung entlang von Teilbereichen des Verfahrwegs der Fahreinrichtung zu verlagern. Eine starre Anbindung der Bildaufnahmeeinrichtung an die Fördereinrichtung kann auch eine Auswertung beziehungsweise Weiterverarbeitung der von der Bildaufnahmeeinrichtung aufgenommenen Bildaufnahmen vereinfachen.

Durch ein sukzessives Verlagern entlang des Verfahrwegs kann die Bildaufnahmeeinrichtung Bildaufnahmen von verschiedenen Teilbereichen der tragenden Struktur der Fahreinrichtung aufnehmen. Da zumindest Teile dieser tragenden Struktur und ihrer zu vermessenden Strukturkomponenten unterhalb der Tritteinheiten der Fördereinrichtung angeordnet sind, wird zunächst mindestens eine der Tritteinheiten, vorzugsweise zwei oder drei Tritteinheiten, zeitweise entfernt, um einen visuellen Zugang zu darunterliegenden zu vermessenden Strukturkomponenten zu erlangen. Die Tritteinheiten können verhältnismäßig einfach auch von nicht spezialisiertem Personal entfernt werden. Durch die hierdurch gebildete Öffnung innerhalb der Fördereinrichtung kann die Bildaufnahmeeinrichtung Bildaufnahmen der darunterliegenden Strukturkomponenten aufnehmen.

Wenn die Fördereinrichtung zusammen sowohl mit der daran fixierten Bildaufnahmeeinrichtung als auch der darin ausgebildeten Öffnung sukzessive entlang des Verfahrwegs der Fahreinrichtung verlagert werden, können Bildaufnahmen aus verschiedenen Positionen heraus und somit in verschiedenen Blickrichtungen aufgenommen werden. Dabei müssen nicht zwingend alle Strukturkomponenten abgebildet werden beziehungsweise es müssen nicht alle Strukturkomponenten vollständig in Bildaufnahmen aufgenommen werden, sondern es kann genügen, zum Beispiel lediglich die für die Modernisierung der Fahreinrichtung notwendigen Bereiche der tragenden Struktur in dem 3D-Modell zu berücksichtigen. Es kann dabei unter anderem genügen, die Bildaufnahmeeinrichtung lediglich über Teile des Verfahrwegs der Fördereinrichtung zu verlagern. Es wird jedoch als vorteilhaft angenommen, die Bildaufnahmeeinrichtung entlang im Wesentlichen des gesamten Vorlaufbereichs des Verfahrwegs zu verlagern.

Gemäß einer Ausführungsform wird vorgeschlagen, als Bildaufnahmeeinrichtung eine 3D-Bildaufnahmeeinrichtung einzusetzen, die zur Aufnahme von dreidimensionalen Bildaufnahmen ausgelegt ist.

Mit anderen Worten kann die Bildaufnahmeeinrichtung dazu ausgestaltet sein, nicht lediglich eine 2-dimensionale Projektion ihres Blickfeldes aufzunehmen, sondern insbesondere im Rahmen der hierin vorgeschlagenen Verfahren ihr Blickfeld 3-dimensional abzubilden. Aufgenommene dreidimensionale Bildaufnahmen enthalten dabei Informationen sowohl über laterale Abstände zwischen Gegenständen als auch Informationen über deren Tiefe im Raum, d.h. deren Abstand zu der Bildaufnahmeeinrichtung. Vorzugsweise ist die 3D-Bildaufnahmeeinrichtung dabei dazu in der Lage, die 3-dimensionalen Bildaufnahmen maßstabsgetreu aufzunehmen. Aus den an verschiedenen Positionen entlang des Verfahrwegs aufgenommenen 3-dimensionalen Bildaufnahmen kann dann das 3D-Modell in relativ einfacher Weise erzeugt werden.

Eine Bildaufnahmeeinrichtung kann zum Beispiel ein Laserscanner sein. Ein solcher Laserscanner emittiert dabei einen Laserstrahl und rastert (d.h. scanned) diesen sukzessive durch sein Blickfeld. Rückreflektierte Anteile des Laserstrahls werden hierbei detektiert und daraus ein Abbild der Umgebung innerhalb des Blickfeldes erzeugt. Im Falle eines 3D-Laserscanners wird zusätzlich eine Information über Abstände von Gegenständen innerhalb des Blickfeldes relativ zu dem Laserscanner ermittelt. Hierzu können beispielsweise Laufzeiten des ausgesandten Laserstrahls bis zur Detektion der rückreflektierten Anteile gemessen werden.

Alternativ kann die Bildaufnahmeeinrichtung als Kamera ausgebildet sein. Eine solche Kamera kann simultan ein Abbild ihrer Umgebung in ihrem gesamten Blickfeld aufnehmen. Eine 3D-Kamera kann dabei Bildaufnahmen erzeugen, bei denen zu jeder aufgenommenen Oberfläche auch eine Information über deren Abstand zu der Kamera ermittelt wird. Hierzu können unter anderem Laufzeitmessungen eingesetzt werden. Daher werden solche Kameras teilweise auch als TOF-Kameras (Time-Of-Flight) bezeichnet.

Es wird darauf hingewiesen, dass es zwar vorteilhaft sein dürfte, das gewünschte 3D-Modell aus 3D-Bildaufnahmen zu erzeugen, d.h. dass als Bildaufnahmeeinrichtung eine 3D-Bildaufnahmeeinrichtung wie ein 3D-Laserscanner oder eine TOF-Kamera eingesetzt wird. Prinzipiell wird es aber auch als möglich erachtet, dass 3D-Modell aus 2D-Bildaufnahmen, die in verschiedenen Blickrichtungen, d.h. aus verschiedenen Positionen heraus, aufgenommen sind, zu erzeugen. Hierzu kann das 3D-Modell aus den 2D-Bildaufnahmen beispielsweise mittels stereoskopischer Techniken ermittelt werden.

Das auf vorbeschriebene Weise erzeugte 3D-Modell kann anschließend genutzt werden, um die darin wiedergegebenen Strukturkomponenten der tragenden Struktur zu vermessen. Das 3D-Modell kann hierzu beispielsweise in einem CAD-System (Computer Aided Design) erzeugt und/oder verarbeitet werden.

Das Vermessen des 3D-Modells kann dabei vorteilhaft an einem Ort entfernt zu der Fahreinrichtung durchgeführt werden. Dies kann den Vorteil haben, dass auf das Vermessen des 3D-Modells spezialisiertes teures Fachpersonal nicht selbst an den Ort der Fahreinrichtung reisen braucht.

Mit anderen Worten kann es genügen, dass am Ort der Fahreinrichtung lediglich eine nicht speziell ausgebildete Hilfsperson eine der Trittstufen in der Fahreinrichtung temporär entfernt und die Bildaufnahmeeinrichtung beispielsweise an einer zu der dadurch entstandenen Öffnung benachbarten Trittstufe fixiert und dann einen Verfahrvorgang durchführt, bei dem die Fördereinrichtung der Fahreinrichtung kurzzeitig verlagert wird und dadurch die daran fixierte Bildaufnahmeeinrichtung Bildaufnahmen von verschiedenen Positionen aus aufnehmen kann. Für diese Aktionen benötigt die Hilfsperson lediglich geringfügige technische Kenntnisse. Insbesondere braucht die Hilfsperson keine Spezialkenntnisse über das Vermessen existierender Fahreinrichtungen. Die mithilfe der Bildaufnahmeeinrichtung erzeugten Bildaufnahmen beziehungsweise das daraus erzeugte 3D-Modell kann dann beispielsweise über ein Datennetzwerk an das CAD-System eines Vermessungsspezialisten übertragen werden. Dieser Vermessungsspezialist braucht dabei nicht selbst die Fahreinrichtung vor Ort inspizieren, sondern kann die Strukturkomponenten der tragenden Struktur der Fahreinrichtung mit ausreichender Genauigkeit lediglich anhand des erzeugten 3D-Modells vermessen.

Wie weiter oben erwähnt, wird vor dem Aufnehmen der Bildaufnahmen eine für die Bildaufnahmeeinrichtung eindeutig erkennbare Referenzmarke ortsfest an der Fahrtreppe beziehungsweise dem Fahrsteig an einer Stelle innerhalb des Verfahrwegs angebracht oder mehrere für die Bildaufnahmeeinrichtung eindeutig erkennbare Referenzmarken werden ortsfest an der Fahrtreppe beziehungsweise dem Fahrsteig an verschiedenen Stellen entlang des Verfahrwegs angebracht.

Mit anderen Worten kann die Fahreinrichtung, bevor mit dem Aufnehmen der Bildaufnahmen begonnen wird, durch Anbringen einer oder mehrerer Referenzmarken geeignet vorbereitet werden, um beispielsweise nachfolgend aus den aufgenommenen Bildaufnahmen das gewünschte 3D-Modell einfacher und/oder präziser erzeugen zu können und/oder um dieses besser auswerten zu können. Beim Erzeugen des 3D-Modells können die Referenzmarken dann beispielsweise als Orientierung, zur Bildung eines Maßstabs, oder ähnlichem genutzt werden.

Als Referenzmarken können beispielsweise selbstklebende oder einfach zu befestigende Marker verwendet werden. Die Referenzmarken können mit Mustern, Barcodes oder Ähnlichem versehen sein. Die Muster beziehungsweise Barcodes können bei den verschiedenen Referenzmarken unterschiedlich ausgebildet sein, sodass diese voneinander unterscheidbar sind. Die Referenzmarken können auch als Zentriermarken, d.h. zum Beispiel ähnlich einer Zielscheibe, ausgebildet sein.

Die Referenzmarken können an vorbestimmten Positionen entlang der Fahreinrichtung angebracht werden. Alternativ können Referenzmarken an beliebigen Positionen an der Fahreinrichtung angebracht werden. Insbesondere können die Referenzmarken an Teilen der Balustrade und/oder der zu vermessenden Strukturkomponenten angebracht werden. Positionen der Referenzmarken relativ zueinander können gegebenenfalls präzise vermessen werden. Hierbei kann es nur auf die Positionen beziehungsweise Abstände der Referenzmarken relativ zueinander ankommen, eine Absolutpositionierung der Referenzmarken an der Fahreinrichtung kann von geringer oder keiner Relevanz sein.

Gemäß einer Ausführungsform der Erfindung können beim Erzeugen des 3D-Modells mehrere Bildaufnahmen unter Berücksichtigung von in den Bildaufnahmen mitaufgenommenen Referenzmarken zu einer Gesamtaufnahme zusammengesetzt werden.

Mit anderen Worten können die zuvor an der Fahreinrichtung angebrachten Referenzmarken dazu genutzt werden, um mehrere einzeln aufgenommene Bildaufnahmen anschließend zu einer Gesamtaufnahme zusammensetzen zu können, um aus dieser dann das 3D-Modell erzeugen zu können. Es kann vorteilhaft sein, die Referenzmarken derart an der Fahreinrichtung entlang des Verfahrwegs anzuordnen und/oder Bildaufnahmen entlang des Verfahrwegs an geeigneten Positionen derart aufzunehmen, dass in jeder aufgenommenen Bildaufnahme zumindest eine, vorzugsweise wenigstens zwei Referenzmarken mit aufgenommen sind. Insbesondere, wenn die Referenzmarken jeweils unterschiedlich ausgebildet sind und somit voneinander unterscheidbar sind, kann aufgrund der in den Bildaufnahmen mitaufgenommenen Referenzmarken eindeutig ermittelt werden, an welcher Position eine Bildaufnahme aufgenommen wurde und wie diese mit anderen Bildaufnahmen zusammengesetzt werden kann.

Gemäß einer Ausführungsform der Erfindung können beim Erzeugen des 3D-Modells Verzerrungen in den Bildaufnahmen anhand von in den Bildaufnahmen mitaufgenommenen Referenzmarken korrigiert werden.

Ähnlich wie bei der vorangehend beschriebenen Ausführungsform können die Referenzmarken somit wiederum dazu genutzt werden, um das gewünschte 3D-Modell erzeugen zu können. Dabei kann durch Berücksichtigung der an vorbekannten Positionen und/oder in vorbekannten Abständen zueinander angebrachten Referenzmarken erkannt werden, ob es in den Bildaufnahmen zu Verzerrungen, beispielsweise verursacht durch optische Fehler der Bildaufnahmeeinrichtung, gekommen ist. Insbesondere kann es wichtig sein, aus den aufgenommenen Bildaufnahmen auf tatsächliche Abmessungen und Geometrien der aufgenommenen Strukturkomponenten rückschließen zu können und dabei virtuelle Aufnahmefehler in Form von Verzerrungen von realen Geometrien der Strukturkomponenten unterscheiden zu können. Beispielsweise können sich die Strukturkomponenten, welche anfänglich meist in Form gerader Streben oder Holme ausgebildet sind, im Laufe der Zeit verformen oder verbiegen. In den aufgenommenen Bildaufnahmen sind dann gekrümmte Strukturkomponenten zu erkennen. Allerdings können die Strukturkomponenten auch weiterhin gerade sein und lediglich aufgrund von optischen Verzerrungen in den Bildaufnahmen gekrümmt erscheinen. Mithilfe der zuvor angebrachten Referenzmarken können die virtuellen Verzerrungen von realen Krümmungen unterschieden werden. Solche Verzerrungen können dann geeignet herausgerechnet werden und damit die Genauigkeit beziehungsweise Maßstabstreue des erzeugten 3D-Modells verbessert werden.

Als weitere mögliche Ausführungsform der Erfindung kann das erzeugte 3D-Modell anhand von in den Bildaufnahmen mitaufgenommenen Referenzmarken kalibriert werden.

Mit anderen Worten können die an vorbekannten beziehungsweise genau vermessenen Positionen angebrachten Referenzmarken dazu genutzt werden, um das erzeugte 3D-Modell zu kalibrieren. In einem derart kalibrierten 3D-Modell sind insbesondere Abmessungen von Strukturkomponenten oder Abstände zwischen Strukturkomponenten maßstabsgetreu wiedergegeben, sodass mithilfe des 3D-Modells solche Abmessungen oder Abstände genau vermessen werden können.

Gemäß einer Ausführungsform können die Bildaufnahmen während des kontinuierlichen Verlagerns der Fördereinrichtung aufgenommen werden.

Anders ausgedrückt kann die Fördereinrichtung derart kontinuierlich umlaufend verlagert werden, dass mit ihr die an ihr fixierte Bildaufnahmeeinrichtung kontinuierlich beispielsweise von einer Extremalposition zu einer zweiten Extremalposition, d.h. beispielsweise von einem Anfang des Förderbereichs bis zu einem Ende des Förderbereichs, bewegt wird. Auf dem Verfahrweg zwischen den beiden Extremalpositionen kann die Bildaufnahmeeinrichtung dann mehrere Bildaufnahmen von verschiedenen Positionen aus aufnehmen. Die Fördereinrichtung braucht hierzu nicht zwingend angehalten zu werden, sodass eine Verfahrdauer kurz gehalten werden kann und/oder eine Ansteuerung der Fahreinrichtung einfach gehalten werden kann.

Alternativ kann gemäß einer Ausführungsform das Verlagern der Fördereinrichtung während des Aufnehmens der Bildaufnahmen temporär unterbrochen werden.

Mit anderen Worten kann die Bildaufnahmeeinrichtung zwar wieder von der Fördereinrichtung von einer Position zu einer zweiten Position verlagert werden. Dabei wird der Verlagerungsvorgang jedoch ein oder mehrere Male kurzzeitig unterbrochen, das heißt die Fördereinrichtung wird kurzzeitig gestoppt, sodass die Bildaufnahmeeinrichtung die Bildaufnahmen während eines Stillstands aufnehmen kann. Eine Qualität der Bildaufnahmen kann hierdurch im Allgemeinen verbessert werden, da es beispielsweise nicht zu Unschärfen aufgrund von Ruckeln oder Wackeln der Bildaufnahmeeinrichtung kommt.

Gemäß einer Ausführungsform kann die Bildaufnahmeeinrichtung mit einer Steuerung der Fahrtreppe beziehungsweise des Fahrsteigs Signale austauschen, um das Aufnehmen der Bildaufnahmen mit dem Verlagern der Fördereinrichtung zu koordinieren.

Anders ausgedrückt können die Bildaufnahmeeinrichtung und die Steuerung der Fahreinrichtung derart in Kommunikation stehen, dass die Bildaufnahmeeinrichtung beispielsweise in Abhängigkeit von einem aktuellen Verlagerungszustand der Fördereinrichtung, koordiniert Bildaufnahmen aufnehmen kann. Beispielsweise kann die Bildaufnahmeeinrichtung aufgrund der von der Steuerung der Fahreinrichtung erhaltener Signale erkennen, wenn sie eine bestimmte Position erreicht hat, und kann von dieser Position aus dann eine Bildaufnahme aufnehmen. Alternativ oder ergänzend kann die Bildaufnahmeeinrichtung durch Signalübertragung die Steuerung der Fahreinrichtung dazu veranlassen, kurzzeitig stehenzubleiben, um eine Bildaufnahme aufnehmen zu können. Die Bildaufnahmeeinrichtung und die Steuerung der Fahreinrichtung können in unterschiedlicher Weise miteinander kommunizieren, zum Beispiel über eine zuvor einzurichtende Kabelverbindung oder alternativ beispielsweise über eine drahtlose Funkverbindung.

Gemäß einer Ausführungsform kann die Bildaufnahmeeinrichtung dazu eingerichtet sein, ein Ende des Förderbereichs zu erkennen und daraufhin der Steuerung der Fahrtreppe beziehungsweise des Fahrsteigs zu signalisieren, das Verlagern der Fördereinrichtung zu beenden.

Mit anderen Worten kann die Bildaufnahmeeinrichtung beispielsweise anhand der von ihr aufgenommenen Bildaufnahmen erkennen, wenn sie sich einem Ende des Förderbereichs nähert. Die in Kommunikation mit der Steuerung der Fahreinrichtung stehende Bildaufnahmeeinrichtung kann daraufhin die Steuerung anweisen, die Fahreinrichtung anzuhalten.

Der Bildaufnahmevorgang kann somit beispielsweise von einer Person gestartet werden, sobald die Bildaufnahmeeinrichtung korrekt an der Fördereinrichtung fixiert ist und gleichzeitig oder nachfolgend kann die Steuerung der Fördereinrichtung entsprechend getriggert werden, um die Bildaufnahmeeinrichtung entlang des Verfahrwegs zu fördern. Wenn die Bildaufnahmeeinrichtung beispielsweise ein gegenüberliegendes Ende des Verfahrwegs beziehungsweise des Förderbereichs erreicht oder sich diesem nähert, kann die Bildaufnahmeeinrichtung dies selbstständig an die Steuerung der Fahreinrichtung mitteilen und diese instruieren, den Fördervorgang zu stoppen. Dann kann die Bildaufnahmeeinrichtung wieder von der Fördereinrichtung demontiert werden. Das gesamte Verfahren kann hierdurch vereinfacht werden. Insbesondere können Beschädigungen der Bildaufnahmeeinrichtung durch Kollision mit Teilen der Fahreinrichtung vermieden werden.

Es wird darauf hingewiesen, dass einige der möglichen Merkmale und Vorteile der Erfindung hierin mit Bezug auf unterschiedliche Ausführungsformen beschrieben sind. Insbesondere sind manche Merkmale mit Bezug auf ein erfindungsgemäßes Verfahren und andere Merkmale mit Bezug auf eine erfindungsgemäße Vorrichtung beschrieben. Ein Fachmann erkennt, dass die Merkmale in geeigneter Weise kombiniert, angepasst oder ausgetauscht werden können, um zu weiteren Ausführungsformen der Erfindung zu gelangen.

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.

Fig. 1 zeigt eine Fahrtreppe mit einer Vorrichtung zum Erzeugen eines 3D-Modells von Strukturkomponenten einer tragenden Struktur der Fahrtreppe gemäß einer Ausführungsform der vorliegenden Erfindung.

Fig. 2 zeigt eine tragende Struktur in Form eines Fachwerks für eine Fahrtreppe.

Die Figuren sind lediglich schematisch und nicht maßstabsgetreu. Gleiche Bezugszeichen bezeichnen in den verschiedenen Figuren gleiche oder gleichwirkende Merkmale

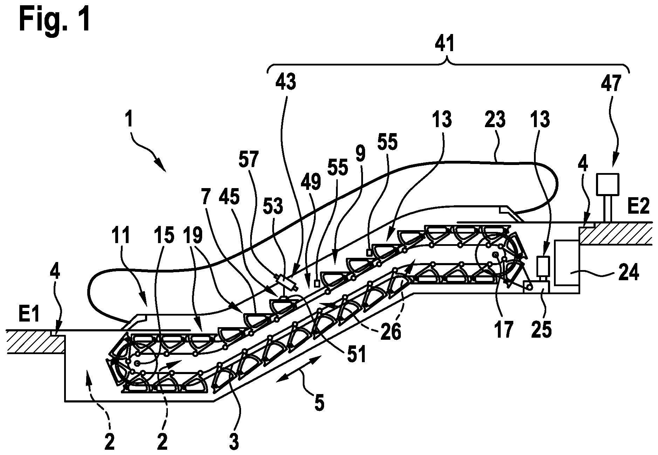

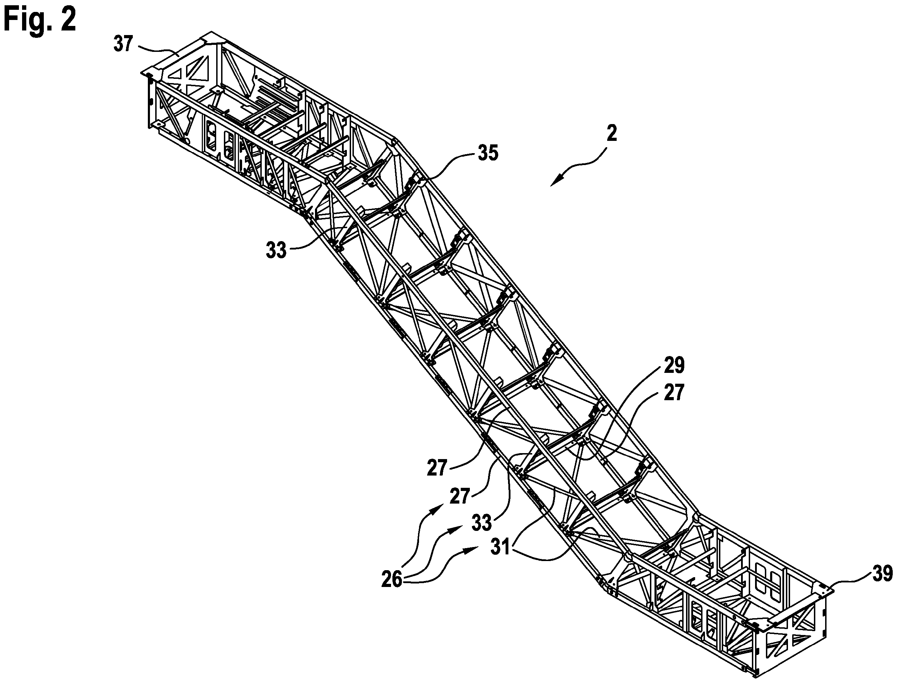

Fig. 1 zeigt eine Seitenansicht einer beispielhaften Fahrtreppe 1, mithilfe derer Personen beispielsweise zwischen zwei Niveaus E1, E2 befördert werden können. Fig. 2 zeigt eine perspektivische Ansicht einer tragenden Struktur 2 in Form eines Fachwerks für eine solche Fahrtreppe 1. Die in Fig. 2 dargestellte tragende Struktur 2 kann dazu eingesetzt werden, um insbesondere die in Fig. 1 dargestellten Komponenten der Fahrtreppe 1 aufzunehmen und diese innerhalb eines Gebäudes zu fixieren und ihr Gewicht auf das Gebäude zu übertragen. Die tragende Struktur 2 und deren Strukturkomponenten 26 wurden in Fig. 2 lediglich zur Veranschaulichung dargestellt und in Fig. 1 lediglich bezüglich ihrer Positionen mit gestrichelten Pfeilen angedeutet, aber im Detail weggelassen, um eine Übersichtlichkeit der Fig. 1 nicht zu stören.

Die Fahrtreppe 1 weist zwei ringförmig geschlossene Förderketten 3 auf. Die beiden Förderketten 3 sind aus einer Vielzahl von Kettengliedern zusammengesetzt. Die beiden Förderketten 3 können entlang eines Verfahrwegs 5 in Verfahrrichtungen verlagert werden. Die Förderketten 3 verlaufen über weite Bereiche hin parallel zueinander und sind dabei in einer Richtung quer zu der Verfahrrichtung voneinander beabstandet. In Endbereichen angrenzend an die Niveaus E1, E2 werden die Förderketten 3 durch Umlenkräder 15, 17 umgelenkt.

Zwischen den beiden Förderketten 3 erstrecken sich mehrere Tritteinheiten 7 in Form von Trittstufen. Jede Tritteinheit 7 ist dabei nahe ihren seitlichen Enden an jeweils einer der Förderketten 3 befestigt und kann somit mithilfe der Förderketten 3 in den Verfahrrichtungen entlang des Verfahrwegs 5 verfahren werden. Die an den Förderketten 3 geführten Tritteinheiten 7 bilden dabei ein Transportband 9, bei dem die Tritteinheiten 7 entlang des Verfahrwegs 5 hintereinander angeordnet sind und zumindest in einem Förderbereich 19 von Passagieren betreten werden können. Um die Förderketten 3 verlagern zu können, verfügt die Fahrtreppe 1 über eine Antriebsanordnung 25 und eine diese steuernde Steuerung 24 (welche in Figur 1 lediglich sehr schematisch angedeutet sind). Das Transportband 9 bildet zusammen mit der Antriebsanordnung 25 und den Umlenkrädern 15, 17 eine Fördereinrichtung 13, deren Tritteinheiten 9 relativ zu der in dem Gebäude stationär fest verankerten tragenden Struktur 2 verlagert werden können.

Die tragende Struktur 2 ist aus Gründen der Übersichtlichkeit nicht in Figur 1 sondern separat in Figur 2 dargestellt. Die tragende Struktur 2 ist als Fachwerk ausgebildet, welches durch eine Vielzahl von Strukturkomponenten 26 wie Längsstreben 27, Querstreben 29, Diagonalstreben 31, Stehern 33, Anbauteilen 35, etc. zusammengesetzt ist. Die Strukturkomponenten 26 sind dabei vorzugsweise starr miteinander verbunden, beispielsweise durch Schweiß-, Schraub-, Clinch- oder Nietverbindungen. Die tragende Struktur 2 kann an Ansatzstellen 37, 39 an entsprechenden tragfähigen Teilen 4 (siehe Fig. 1) des Gebäudes befestigt werden.

Die verschiedenen Komponenten der Fördereinrichtung 13 sind mit der tragenden Struktur 2 verbunden und werden durch diese gestützt. Hierzu können die Komponenten der Fördereinrichtung 13 beispielsweise mithilfe von Adapterplatten oder ähnlichem an einzelnen oder mehreren Strukturkomponenten 26 befestigt werden.

Die Fahrtreppe 1 verfügt ferner über einen an einer Balustrade 11 angeordneten Handlauf 23, welcher im Allgemeinen zusammen mit den Förderketten 3 angetrieben wird und sich somit synchron mit dem Transportband 9 bewegt.

Nach einer gewissen Betriebsdauer kann eine Fahrtreppe 1 modernisiert werden, um diese auf den neusten technischen Stand zu bringen. Hierbei übersteigt der Aufwand die üblichen Revisions- und Unterhaltsarbeiten, bei denen lediglich Verschleißteile ersetzt werden. Bei Modernisierungen sollen nicht selten auch die Sicherheitselemente und die elektrische Ausrüstung den neusten Anforderungen und Sicherheitsstandards angepasst werden.

Während im Rahmen von Modernisierungsmaßnahmen herkömmlich die zu ersetzenden Komponenten vollständig entfernt wurden und dann die verbleibenden Komponenten der tragenden Struktur 2 präzise von Hand vermessen werden mussten, wird hierin ein alternatives Verfahren unter Verwendung einer Vorrichtung 41 beschrieben. Die Vorrichtung 41 ist dabei dazu ausgebildet, ein 3D-Modell der Strukturkomponenten 26 der tragenden Struktur 2 der Fahrtreppe 1 zu erzeugen, welches dann zu Vermessungszwecken genutzt werden kann.

Wie in Figur 1 schematisch dargestellt, verfügt die Vorrichtung 41 über eine Bildaufnahmeeinrichtung 43. Die Bildaufnahmeeinrichtung 43 ist mithilfe einer Fixiereinrichtung 45 an der Fördereinrichtung 13 fixiert. Ferner ist die Vorrichtung 41 mit einer Recheneinrichtung 47 ausgestattet.

Im Rahmen eines Modernisierungsvorgangs kann Personal eine oder wenige der Tritteinheiten 7 an der zu modernisierenden Fahrtreppe 1 vorab entfernen. Hierzu benötigt das Personal im Allgemeinen keine speziellen Fachkenntnisse, sodass diese Tätigkeit auch beispielsweise von Hilfspersonal durchgeführt werden kann. Gegebenenfalls können auch andere Abdeckungen wie beispielsweise Verschalungsbleche eines Balustradensockels entfernt werden. Dadurch wird eine Öffnung 49 in dem Transportband 9 freigelegt. Durch diese Öffnung 49 hindurch wird ein visueller Zugang auf Teile der darunterliegenden tragenden Struktur 2 freigegeben.

Anschließend wird die Bildaufnahmeeinrichtung 43 an der Fördereinrichtung 13 mithilfe ihrer Fixiereinrichtung 45 fixiert. Insbesondere kann die Bildaufnahmeeinrichtung 43 derart an der Fördereinrichtung 13 fixiert werden, dass ihr Blickbereich auf die Öffnung 49 und die darunterliegende tragende Struktur 2 gerichtet ist. Anfangs kann die Bildaufnahmeeinrichtung 43 beispielsweise nahe einem Ende des Förderbereichs 19, beispielsweise in der Nähe des Zugangs auf dem unteren Niveau E1, angeordnet werden.

Im dargestellten Beispiel ist die Fixiereinrichtung 45 in Form eines Fußes 51 ausgebildet, der einerseits dazu ausgestaltet ist, die Bildaufnahmeeinrichtung 43 zu tragen, und der andererseits dazu ausgestaltet ist, an einer der Tritteinheiten 7 befestigt zu werden. Der Fuß 51 kann dabei beispielsweise in Nuten innerhalb der Tritteinheit 7 eingreifen.

Alternativ könnte die Fixiereinrichtung 45 auch dazu ausgebildet sein, statt mit einer der Tritteinheiten 7 mit anderen Komponenten des Transportbandes 9, beispielsweise einer Förderkette 3 oder daran ansetzenden Achsen, zusammen zu wirken. Auch der Anbau an die umlaufend angeordneten Handläufe beziehungsweise an die Handlaufriemen ist möglich.

Sobald die Öffnung 49 durch Entfernen von Tritteinheiten 7 generiert und die Bildaufnahmeeinrichtung 43 an der Fördereinrichtung 13 befestigt ist, kann die Bildaufnahmeeinrichtung 43 sukzessive entlang des Verfahrwegs 5 innerhalb des Förderbereichs 19 verlagert werden. Dabei kann ein Blickbereich der Bildaufnahmeeinrichtung 43 durch die Öffnung 49 hindurch auf darunterliegende Strukturkomponenten 26 gerichtet sein und Bildaufnahmen von diesen aufnehmen.

Die Bildaufnahmeeinrichtung 43 kann vorzugsweise dazu ausgestaltet sein, dreidimensionale Bilder der tragenden Struktur 2 innerhalb ihres Blickbereichs aufzunehmen. Hierzu kann die Bildaufnahmeeinrichtung 43 beispielsweise als 3D-Laserscanner oder als TOF-Kamera 53 ausgebildet sein.

Um möglichst Bildaufnahmen entlang der gesamten tragenden Struktur 2 aufnehmen zu können, kann die an der Fördereinrichtung 13 fixierte Bildaufnahmeeinrichtung 43 zusammen mit dem Transportband 9 sukzessive entlang des Verfahrwegs 5 innerhalb des Förderbereichs 19 verfahren werden und dabei von verschiedenen Positionen aus mehrere Bildaufnahmen aufnehmen.

Zu den Bildaufnahmen gehörende Daten beziehungsweise Signale können dann an die Recheneinrichtung 47 übertragen werden. Die Recheneinrichtung 47 kann dabei direkt an der Bildaufnahmeeinrichtung 43 vorgesehen sein oder sogar in diese integriert sein. In diesem Fall kann das 3D-Modell direkt in der mit der Recheneinrichtung 47 ausgestatteten Bildaufnahmeeinrichtung 43 erzeugt werden. Nachfolgend kann das erzeugte 3D-Modell gegebenenfalls an ein Kontrollzentrum übermittelt werden, um es dort auszuwerten.

Alternativ kann die Recheneinrichtung 47, wie in Figur 1 beispielhaft dargestellt, als separate Einheit bereitgestellt sein. Eine solche separate Recheneinrichtung 47 kann beispielsweise in der Nähe der Fahrtreppe 1 angeordnet sein und mit der Bildaufnahmeeinrichtung 43 beispielsweise über eine drahtlose Datenverbindung kommunizieren. Alternativ kann die Recheneinrichtung 47 auch weiter entfernt angeordnet sein, beispielsweise in einem Kontrollzentrum, welches sich außerhalb des Gebäudes oder sogar in einer anderen Stadt befindet. In diesem Fall können Daten und Signale der Bildaufnahmeeinrichtung 43 beispielsweise über ein verdrahtetes oder drahtloses Netzwerk an die Recheneinrichtung 47 übertragen werden.

Aus den von der Bildaufnahmeeinrichtung 43 erhaltenen Daten der Bildaufnahmen kann innerhalb der Recheneinrichtung 47 ein dreidimensionales Modell der von der Bildaufnahmeeinrichtung 43 aufgenommenen tragenden Struktur 2 der Fahrtreppe 1 generiert werden. Anhand dieses 3D-Modells können die Abmessungen der einzelnen Strukturkomponenten 26 und/oder deren Lage und Orientierung relativ zueinander präzise vermessen werden.

Basierend auf den dabei erhaltenen Vermessungsdaten können Fachleute dann Vorbereitungen treffen, um bisherige Komponenten der Fördereinrichtung 13 nach deren Entfernen durch neue Komponenten ersetzen zu können. Insbesondere können die neuen Komponenten beziehungsweise zur Montage vorgesehene Adapterstücke oder Ähnliches bereits geeignet dimensioniert oder angepasst werden, sodass sie dann schnell und problemlos am Einsatzort in die verbliebene tragende Struktur 2 montiert werden können.

Um das Aufnehmen der Bildaufnahmen sowie das Generieren des 3D-Modells basierend auf mehreren aufgenommenen Bildaufnahmen vereinfachen oder präzisieren zu können, können vor dem Aufnahmevorgang entlang des Verfahrwegs 5 in dem Förderbereich 19 vorzugsweise mehrere eindeutig erkennbare Referenzmarken 55 angeordnet werden. Die Referenzmarken 55 können beispielsweise als Aufkleber mit einem eindeutig zuzuordnenden Code, beispielsweise einem Barcode oder QR-Code, vorgesehen sein.

Die Referenzmarken 55 können dabei derart angeordnet werden, dass sie innerhalb des Blickfelds der Bildaufnahmeeinrichtung 43 sind, zumindest wenn diese an bestimmten Aufnahmepositionen angeordnet ist. Die Aufnahmepositionen können dabei derart gewählt sein, dass in jeder Bildaufnahme mindestens eine Referenzmarke 55, vorzugsweise wenigstens zwei Referenzmarken 55 mit aufgenommen werden.

Aufgrund der mitaufgenommenen Referenzmarken 55 kann nachfolgend ein Gesamtbild aus den einzelnen Bildaufnahmen einfacher generiert werden und/oder dieses kalibriert werden und/oder etwaige beispielsweise durch Aufnahmefehler bedingte Verzerrungen herausgerechnet werden.

Gegebenenfalls kann die Bildaufnahmeeinrichtung 43 ferner dazu ausgestaltet sein, mithilfe einer Signalaustauscheinrichtung 57 mit der Steuerung 24 der Fahrtreppe 1 zu kommunizieren. Beispielsweise kann die Steuerung 24 immer dann dazu veranlasst werden, die Antriebsanordnung 25 der Fahrtreppe 1 zu stoppen, wenn die Bildaufnahmeeinrichtung 43 bestimmte Positionen erreicht hat, sodass die Bildaufnahmeeinrichtung 43 an diesen Positionen bei stillstehender Fördereinrichtung 13 ohne Verwacklungen Bildaufnahmen aufnehmen kann. Ferner kann die Bildaufnahmeeinrichtung 43 die Steuerung 24 dazu veranlassen, den Betrieb der Antriebsanordnung 25 zu stoppen, sobald die Bildaufnahmeeinrichtung 43 den Förderbereich 19 vollständig durchfahren hat und sich beispielsweise dessen gegenüberliegendem Ende nähert.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Ferner sei daraufhingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Verfahren zum Erzeugen eines 3D-Modells von Strukturkomponenten (26) einer tragenden Struktur (2) einer Fahrtreppe (1) oder eines Fahrsteiges,
wobei die Fahrtreppe (1) beziehungsweise der Fahrsteig eine Fördereinrichtung (13) mit mehreren entlang eines umlaufenden Verfahrwegs (5) verlagerbaren Tritteinheiten (7) aufweist,
wobei das Verfahren die Verfahrensschritte aufweist:
dass eine Bildaufnahmeeinrichtung (43) an der Fördereinrichtung (13) fixiert wird;
dass zumindest eine der Tritteinheiten (7) entfernt wird, um einen visuellen Zugang zu darunterliegenden zu vermessenden Strukturkomponenten (26) zu eröffnen;
dass vor dem Aufnehmen von Bildaufnahmen, ortsfest an der Fahrtreppe (1) beziehungsweise am Fahrsteig, an mindestens einer Stelle innerhalb des Verfahrwegs (5) mindestens eine Referenzmarke (55) angebracht wird die für die Bildaufnahmeeinrichtung (43) eindeutig erkennbar ist;
dass die Fördereinrichtung (13) zusammen mit der daran fixierten Bildaufnahmeeinrichtung (43) zumindest über Teilbereiche des Verfahrwegs (5) umlaufend verlagert wird;
dass Bildaufnahmen der zu vermessenden Strukturkomponenten (26) mittels der Bildaufnahmeeinrichtung (43) von mehreren Positionen entlang des Verfahrwegs (5) aus aufgenommen werden; und
dass das Erzeugen des 3D-Modells zumindest von Teilbereichen der Strukturkomponenten (26) der tragenden Struktur (2) basierend auf den aufgenommenen Bildaufnahmen und unter Zuhilfenahme der mindestens einen, mitaufgenommenen Referenzmarke (55) erfolgt.

2. Verfahren nach Anspruch 1, wobei beim Erzeugen des 3D-Modells mehrere Bildaufnahmen unter Berücksichtigung von in den Bildaufnahmen mitaufgenommenen Referenzmarken (55) zu einer Gesamtaufnahme zusammengesetzt werden.

3. Verfahren nach einem der vorangehenden Ansprüche 1 oder 2, wobei beim Erzeugen des 3D-Modells Verzerrungen in den Bildaufnahmen anhand von in den Bildaufnahmen mitaufgenommenen Referenzmarken (55) korrigiert werden.

4. Verfahren nach einem der vorangehenden Ansprüche 1 bis 3, wobei das erzeugte 3D-Modell anhand von in den Bildaufnahmen mitaufgenommenen Referenzmarken (55) kalibriert wird.

5. Verfahren nach einem der vorangehenden Ansprüche, wobei die Bildaufnahmen während des kontinuierlichen Verlagerns der Fördereinrichtung (13) aufgenommen werden.

6. Verfahren nach einem der vorangehenden Ansprüche 1 bis 4, wobei das Verlagern der Fördereinrichtung (13) während des Aufnehmens der Bildaufnahmen temporär unterbrochen wird.

7. Verfahren nach einem der vorangehenden Ansprüche, wobei die Bildaufnahmeeinrichtung (43) mit einer Steuerung (24) der Fahrtreppe (1) beziehungsweise des Fahrsteigs Signale austauscht, um das Aufnehmen der Bildaufnahmen mit dem Verlagern der Fördereinrichtung (13) zu koordinieren.

8. Verfahren nach einem der vorangehenden Ansprüche, wobei die Tritteinheiten (7) zumindest in einem Förderbereich (19) von Passagieren betreten werden können und die Bildaufnahmeeinrichtung (43) dazu eingerichtet ist, ein Ende des Förderbereichs (19) zu erkennen und daraufhin der Steuerung (24) der Fahrtreppe (1) beziehungsweise des Fahrsteigs zu signalisieren, das Verlagern der Fördereinrichtung (19) zu beenden.

9. Verfahren zum Vermessen von Strukturkomponenten (26) einer tragenden Struktur (2) einer Fahrtreppe (1) oder eines Fahrsteiges, umfassend:
Erzeugen eines 3D-Modells der Strukturkomponenten (26) der tragenden Struktur (2) mittels eines Verfahrens gemäß einem der Ansprüche 1 bis 8;
Vermessen der Strukturkomponenten (26) anhand des 3D-Modells.

10. Verfahren zum Modernisieren einer Fahrtreppe (1) oder eines Fahrsteigs, umfassend:
Ermitteln von Abmessungen innerhalb einer tragenden Struktur (2) der Fahrtreppe (1) beziehungsweise des Fahrsteiges durch Vermessen von Strukturkomponenten (26) der tragenden Struktur (2) mittels des Verfahrens gemäß Anspruch 9;
Entfernen von an der tragenden Struktur (2) befestigten alten Komponenten der Fahrtreppe (1) beziehungsweise des Fahrsteigs;
Anbringen von neuen Komponenten der Fahrtreppe (1) beziehungsweise des Fahrsteigs an der tragenden Struktur (2), wobei eine Positionierung der neuen Komponenten an der tragenden Struktur (2) unter Berücksichtigung der zuvor ermittelten Abmessungen innerhalb der tragenden Struktur (2) erfolgt.

11. Vorrichtung (41) zum Erzeugen eines 3D-Modells von Strukturkomponenten (26) einer tragenden Struktur (2) einer Fahrtreppe (1) oder eines Fahrsteiges, wobei die Fahrtreppe (1) beziehungsweise der Fahrsteig eine Fördereinrichtung (13) mit mehreren entlang eines umlaufenden Verfahrwegs (5) verlagerbaren Tritteinheiten (7) aufweist, wobei die Tritteinheiten (7) entlang des Verfahrwegs (5) hintereinander angeordnet sind und zumindest in einem Förderbereich (19), in dem die Tritteinheiten (7) von Passagieren betreten werden können, oberhalb von zu vermessenden Strukturkomponenten (26) angeordnet sind,
wobei die Vorrichtung (41) aufweist:
eine Bildaufnahmeeinrichtung (43), welche dazu eingerichtet ist, Bildaufnahmen der zu vermessenden Strukturkomponenten (26) aufzunehmen und
eine Fixiereinrichtung (45), welche dazu eingerichtet ist, die Bildaufnahmeeinrichtung (43) an der Fördereinrichtung (13) zu fixieren; **dadurch gekennzeichnet, dass** die Vorrichtung ferner mindestens eine eindeutig erkennbare Referenzmarke (55) aufweist, die ortsfest an der Fahrtreppe (1) beziehungsweise am Fahrsteig an mindestens einer Stelle innerhalb des Verfahrwegs (5) anbringbar ist,
sowie eine Recheneinrichtung (47) aufweist, welche dazu eingerichtet ist, das 3D-Modell zumindest von Teilbereichen der Strukturkomponenten (26) der tragenden Struktur (2) basierend auf von der Bildaufnahmeeinrichtung (43) aufgenommenen Bildaufnahmen unter Zuhilfenahme der auf den Bildaufnahmen mitaufgenommenen Referenzmarken (55) zu erzeugen.

12. Vorrichtung nach Anspruch 11, wobei die Bildaufnahmeeinrichtung (43) eine 3D-Bildaufnahmeeinrichtung zur Aufnahme von 3D-Bildaufnahmen ist.

13. Vorrichtung nach einem der Ansprüche 11 oder 12, ferner aufweisend eine Signalaustauscheinrichtung (57), welche dazu eingerichtet ist, Signale zwischen der Bildaufnahmeeinrichtung (43) und einer Steuerung (24) der Fahrtreppe (1) beziehungsweise des Fahrsteigs auszutauschen, um das Aufnehmen der Bildaufnahmen mit dem Verlagern der Fördereinrichtung (13) zu koordinieren.

## Claims

1. A method for generating a 3D model of structural components (26) of a bearing structure (2) of an escalator (1) or a moving walkway,
wherein the escalator (1) or the moving walkway comprises a conveying means (13) with a number of tread units (7) moveable along a revolving travel path (5),
wherein the method comprises the method steps of:
fixing an image recording device (43) on the conveying means (13);
removing at least one of the tread units (7) in order to enable visual access underneath the tread units to structural components (26) which shall be measured;
prior to recording image recordings, immovably affixing at least one reference mark (55) on the escalator (1) or on the moving walkway in at least one place within the travel path (5) and which reference mark is clearly identifiable for the image recording device (43);
moving the conveying means (13) together with the image recording device (43) fixed to it over at least partial areas of the travel path (5) in a revolving manner;
recording image recordings of the structural components (26) to be measured using the image recording device (43) at a number of positions along the travel path (5); and
effecting the generation of the 3D model at least of partial areas of the structural components (26) of the bearing structure (2) based on the recorded image recordings and with the aid of at least one reference mark (55) recorded together with the images.

2. The method according to claim 1, wherein in generating the 3D model a number of image recordings are combined to form one overall recording taking account the reference marks (55) recorded along with the images.

3. The method according to one of the preceding claims 1 or 2, wherein in generating the 3D model distortions in the image recordings are corrected by way of reference marks (55) recorded along with the images.

4. The method according to one of the preceding claims 1 to 3, wherein the generated 3D model is calibrated by way of reference marks (55) recorded along with the images.

5. The method according to one of the preceding claims, wherein the image recordings are recorded during the continuous movement of the conveying means (13).

6. The method according to one of the preceding claims 1 to 4, wherein movement of the conveying means (13) is temporarily interrupted during the recording of image recordings.

7. The method according to one of the preceding claims, wherein the image recording device (43) exchanges signals with a control (24) of the escalator (1) or the moving walkway, in order to coordinate the recording of image recordings with the movement of the conveying means (13).

8. The method according to one of the preceding claims, wherein the tread units (7) can be stepped on by passengers at least in a conveying region (19) and the image recording device (43) is arranged to detect one end of the conveying region (19) and thereupon signal to the control (24) of the escalator (1) or the moving walkway to terminate moving the conveying means (19).

9. A method for measuring structural components (26) of a bearing structure (2) of an escalator (1) or a moving walkway including:
generating a 3D model of the structural components (26) of the bearing structure (2) by means of a method according to one of claim 1 to 8;
measuring the structural components (26) by way of the 3D model.

10. A method for modernising an escalator (1) or a moving walkway including:
ascertaining dimensions within a bearing structure (2) of the escalator (1) or the moving walkway by measuring structural components (26) of the bearing structure (2) by means of the method according to claim 9;
removing old components from the escalator (1) or the moving walkway attached to the bearing structure (2);
attaching new components of the escalator (1) or the moving walkway to the bearing structure (2), wherein positioning of the new components on the bearing structure (2) is effected taking into account the previously ascertained dimensions within the bearing structure (2).

11. A device (41) for generating a 3D model of structural components (26) of a bearing structure (2) of an escalator (1) or moving walkway, wherein the escalator (1) or the moving walkway comprises a conveying means (13) with a number of tread units (7) moveable along a revolving travel path (5), wherein the tread units (7) are arranged one behind the other along a travel path (5) and, at least in a conveying region (19), in which the tread units (7) can be stepped on by passengers, the tread units are arranged above structural components (26) to be measured,
wherein the device (41) comprises:
an image recording device (43), which is arranged to record image recordings of the structural components (26) to be measured and
a fixing means (45), which is arranged to fix the image recording device (43) on the conveying means (13); **characterised in that** the device furthermore comprises at least one clearly identifiable reference mark (55), which can be immovably affixed on the escalator (1) or the moving walkway in at least one place within the travel path (5), as well as a computing means (47), which is arranged to generate the 3D model at least of partial areas of the structural components (26) of the bearing structure (2) based on image recordings recorded by the image recording device (43) with the aid of reference marks (55) recorded along with the image recordings.

12. The device according to claim 11, wherein the image recording device (43) is a 3D image recording device for recording 3D image recordings.

13. The device according to one of claims 11 or 12, further comprising a signal exchange means (57), which is arranged to exchange signals between the image recording device (43) and a control (24) of the escalator (1) or the moving walkway in order to coordinate the recording of image recordings with the movement of the conveying means (13).

## Revendications

1. Procédé, destiné à générer un modèle en 3D de composants structurels (26) d'une structure porteuse (2) d'un escalator (1) ou d'un trottoir roulant,
l'escalator (1), respectivement le trottoir roulant comportant un système de convoyage (13) doté de plusieurs unités de marches (7) déplaçables le long d'un trajet de déplacement (5) périphérique,
le procédé comportant les étapes de procédé suivantes :
on fixe un système d'enregistrement d'images (43) sur le système de convoyage (13) ;
on retire l'une des unités de marches (7) pour ouvrir un accès visuel à des composants structurels (26) sous-jacents qui doivent être mesurés ;
avant l'enregistrement de prises de vues, on appose de manière stationnaire sur l'escalator (1) respectivement sur le trottoir roulant, en au moins un endroit à l'intérieur du trajet de déplacement (5) au moins une marque de référence (55) qui est indubitablement identifiable par le système d'enregistrement d'images (43) ;
on déplace de manière périphérique le système de convoyage (13) conjointement avec le système d'enregistrement d'images (43) qui y est fixé, au moins sur des zones partielles du trajet de déplacement (5) ;
on enregistre des prises de vues des composants structurels (26) qui doivent être mesurés au moyen du système d'enregistrement d'images (43) à partir de plusieurs positions le long du trajet de déplacement (5) ; et
la génération du modèle en 3D s'effectue au moins à partir de zones partielles des composants structurels (26) de la structure porteuse (2), sur la base des prises de vues enregistrées et à l'aide de l'au moins une marque de référence (55) conjointement enregistrée.

2. Procédé selon la revendication 1, lors de la génération du modèle en 3D, plusieurs prises de vues étant regroupées en une prise globale, sous considération des marques de référence (55) conjointement enregistrées dans les prises de vue.

3. Procédé selon l'une quelconque des revendications précédentes 1 ou 2, lors de la génération du modèle en 3D, des distorsions dans les prises de vues étant corrigées à l'aide de marques de référence (55) conjointement enregistrées dans les prises de vues.

4. Procédé selon l'une quelconque des revendications précédentes 1 à 3, le modèle en 3D généré étant calibré à l'aide de marques de référence (55) conjointement enregistrées dans les prises de vues.

5. Procédé selon l'une quelconque des revendications précédentes, les prises de vues étant enregistrées pendant le déplacement en continu du système de convoyage (13).

6. Procédé selon l'une quelconque des revendications précédentes 1 à 4, le déplacement du système de convoyage (13) étant temporairement interrompu pendant l'enregistrement des prises de vues.

7. Procédé selon l'une quelconque des revendications précédentes, le système d'enregistrement d'images (43) échangeant des signaux avec un système de commande (24) de l'escalator (1), respectivement du trottoir roulant, pour coordonner l'enregistrement des prises de vues avec le déplacement du système de convoyage (13).

8. Procédé selon l'une quelconque des revendications précédentes, les unités de marches (7) pouvant être pratiquées par des passagers dans au moins une zone de convoyage (19) et le système d'enregistrement d'images (43) étant aménagé pour identifier une extrémité de la zone de convoyage (19), pour signaler ensuite à l'attention du système de commande (24) de l'escalator (1), respectivement du trottoir roulant de mettre fin au déplacement du système de convoyage (19).

9. Procédé, destiné à mesurer des composants structurels (26) d'une structure porteuse (2) d'un escalator (1) ou d'un trottoir roulant, comprenant les étapes consistant à :
générer un modèle en 3D des composants structurels (26) de la structure porteuse (2) au moyen d'un procédé selon l'une quelconque des revendications 1 à 8 ;
mesurer les composants structurels (26) à l'aide du modèle en 3D.

10. Procédé, destiné à moderniser un escalator (1) ou un trottoir roulant, comprenant les étapes consistant à :
déterminer des dimensions à l'intérieur d'une structure porteuse (2) de l'escalator (1), respectivement du trottoir roulant en mesurant des composants structurels (26) de la structure porteuse (2) au moyen du procédé selon la revendication 9 ;
retirer des anciens composants de l'escalator (1), respectivement du trottoir roulant fixés sur la structure porteuse (2) ;
monter des nouveaux composants de l'escalator (1), respectivement du trottoir roulant sur la structure porteuse (2), le positionnement des nouveaux composants sur la structure porteuse (2) s'effectuant sous considération des dimensions précédemment déterminées à l'intérieur de la structure porteuse (2).

11. Dispositif (41), destiné à générer un modèle en 3D de composants structurels (26) d'une structure porteuse (2) d'un escalator (1) ou d'un trottoir roulant, l'escalator (1), respectivement le trottoir roulant comportant un système de convoyage (13) doté de plusieurs unités de marches (7) déplaçables le long d'un trajet de déplacement (5) périphérique, les unités de marches (7) étant placées les unes derrière les autres le long du trajet de déplacement (5) et au moins dans une zone de convoyage (19), dans laquelle les unités de marches (7) sont praticables par des passagers, étant placées au-dessus de composants structurels (26) qui doivent être mesurés,
le dispositif (41) comportant :
un système d'enregistrement d'images (43), lequel est aménagé pour enregistrer des prises de vues des composants structurels (26) qui doivent être mesurés et
un système de fixation (45), lequel est aménagé pour fixer le système d'enregistrement d'images (43) sur le système de convoyage (13) ; **caractérisé en ce que** le dispositif comporte par ailleurs au moins une marque de référence (55) indubitablement identifiable, qui est susceptible d'être apposée de manière stationnaire sur l'escalator (1), respectivement sur le trottoir roulant, en au moins un endroit à l'intérieur du trajet de déplacement (5), et comportant également un système de calcul (47), lequel est aménagé pour générer le modèle en 3D d'au moins des zones partielles des composants structurels (26) de la structure porteuse (2) sur la base des prises de vues enregistrées par le système d'enregistrement d'images (43) à l'aide des marques de référence (55) enregistrées conjointement sur les prises de vue.

12. Dispositif selon la revendication 11, le système d'enregistrement d'images (43) étant un système d'enregistrement d'images en 3D, destiné à enregistrer des prises de vue en 3D.

13. Dispositif selon l'une quelconque des revendications 11 ou 12, comportant par ailleurs un système d'échange de signaux (57), lequel est aménagé pour échanger des signaux entre le système d'enregistrement d'images (43) et un système de commande (24) de l'escalator (1), respectivement du trottoir roulant, pour coordonner l'enregistrement des prises de vues avec le déplacement du système de convoyage (13).
